# FASCICULE DE BREVET EUROPEEN

(11) **EP 2 525 406 B1**
(45) Date de publication et mention de la délivrance du brevet: **11.04.2018**
(21) Numéro de dépôt: 12354029.6
(22) Date de dépôt: 16.05.2012
(51) Int. Cl.: H01L 27/146

(54) **Circuit de détection à faible flux et faible bruit**
Detektorschaltkreis mit schwachem Energiefluss und geringem Rauschen
Low-flow, low-noise detection circuit

(30) Priorité: 20.05.2011 FR 1101571
(43) Date de publication de la demande: 21.11.2012
(73) Titulaire: Société Française de Détecteurs Infrarouges - SOFRADIR, 91120 Palaiseau (FR)
(72) Inventeur: Sanson, Eric, 38000 Grenoble (FR)
(74) Mandataire: Talbot, Alexandre

(56) Documents cités:
- EP-A2- 0 917 205
- JP-A- 7 058 308
- US-A1- 2008 210 846
- US-A1- 2010 060 764
- US-A1- 2010 230 729
- CHYE HUAT AW ET AL: "A 128X128-PIXEL STANDARD-CMOS IMAGE SENSOR WITH ELECTRONIC SHUTTER", IEEE INTERNATIONAL SOLID STATE CIRCUITS CONFERENCE, IEEE SERVICE CENTER, NEW YORK, NY, US, vol. 39, 1 février 1996 (1996-02-01), XP000685586, ISSN: 0193-6530

## Description

### Domaine technique de l'invention

L'invention est relative à un circuit de détection de type SFD.

### État de la technique

Afin d'obtenir des capteurs très sensibles, le circuit de détection est réalisé de manière particulière au moyen d'une architecture de type SFD (Source Follower per Detector). Ce type de capteur fonctionne avec des faibles conditions de rayonnement, c'est-à-dire avec un faible flux incident.

Comme dans les détecteurs conventionnels, le rayonnement incident est converti en une quantité d'électrons qui est représentative de la scène observée. Pour ce type de capteur, il est important de limiter le bruit électronique généré par le circuit de détection, c'est-à-dire la quantité d'électrons qui n'est pas liée à la scène observée. Un premier moyen de réduire la quantité d'électrons parasites est de limiter la consommation électrique du circuit ce qui incite à simplifier le circuit de détection. L'intégration des charges émises par le photodétecteur est alors réalisée par le condensateur interne du photodétecteur.

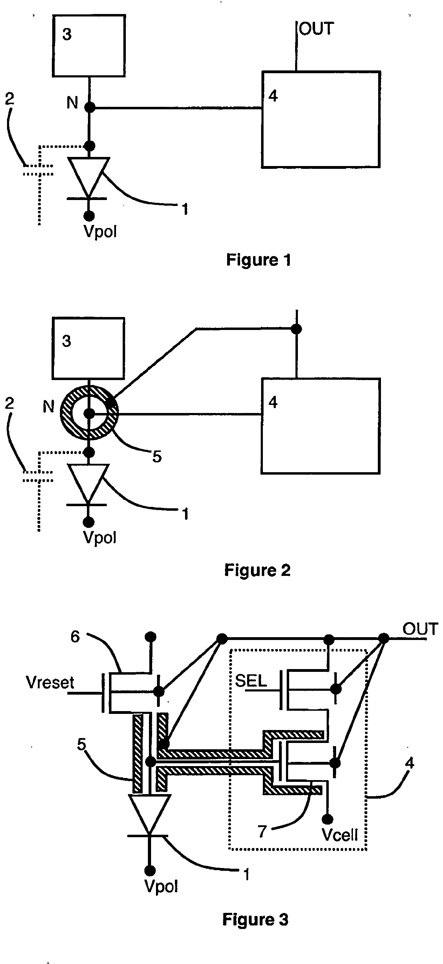

Comme illustré à la figure 1, le circuit de détection comporte une photodiode 1 avec son condensateur interne 2. Le circuit comporte également un circuit de polarisation 3 qui permet de faire basculer la photodiode 1 entre une polarisation inverse et un état flottant.

La photodiode 1 est également connectée à un circuit de lecture 4 qui traite le signal émis par la photodiode 1.

Les. charges générées par la photodiode 1 sont stockées en partie par le condensateur 2 interne de la photodiode 1 ce qui se traduit par une évolution du potentiel du noeud d'intégration N connecté au circuit de lecture 4. La capacité électrique du noeud d'intégration provient en partie de la capacité électrique de la photodiode et en partie des capacités parasites des autres éléments reliés au noeud d'intégration N.

L'amélioration du gain en conversion du détecteur passe également par une réduction de la valeur de la capacité électrique au niveau du noeud d'intégration du circuit de détection, mais la valeur des condensateurs parasites reste généralement du même ordre de grandeur que le condensateur 2. Il existe donc toujours un niveau de bruit important en terme d'électrons dans les détecteurs à faible flux.

Le document XP000685586 (Chye Huat Aw et al.: "A 128x128-pixel standard-CMOS image sensor with electronic shutter", IEEE International Solid-State Circuits Conférence, vol. 39, 1 February 1996) divulgue un circuit de détection de type Source Follower per Detector comportant un blindage métallique disposé au-dessus du noeud d'intégration.

### Objet de l'invention

On constate qu'il existe un besoin de prévoir un circuit de détection qui permette de réduire le niveau de bruit lors d'une utilisation à faible flux.

On tend à assouvir ce besoin au moyen d'un circuit de détection selon la revendication 1.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, un circuit de détection de type SFT selon un example non couvert par les revendications,
- la figure 2 représente, de manière schématique, un autre circuit de détection de type SFD muni d'un blindage selon l'invention,
- les figures 3 et 4 représentent, de manière schématique, deux modes de réalisation particuliers d'un circuit de détection de type SFD muni d'un blindage selon l'invention,
- la figure 5 représente, de manière schématique, en coupe, un autre circuit de détection de type SFD muni d'un blindage entre deux substrats selon l'invention,
- la figure 6 représente, de manière schématique, une matrice de détection munie de plusieurs circuits de détection de type SFD avec un blindage selon l'invention.

### Description de modes de réalisation préférentiels de l'invention

Comme cela est illustré à la figure 2, le circuit de détection de type SFD (Source-Follower per Detector) comporte un photodétecteur 1 qui est une photodiode. Le photodétecteur 1 est associé à un circuit de polarisation 3. Le circuit de polarisation 3 permet de polariser le photodétecteur 1 entre des premier et seconds états. Dans le premier état, le photodétecteur 1 est polarisé en inverse. Dans un deuxième état, le photodétecteur 1 est laissé dans un état flottant où il maintient sa polarisation inverse tout en évoluant vers la polarisation directe en fonction de l'accumulation des charges reçues. Le noeud de rétention N est connecté au photodétecteur 1 lorsque le photodétecteur est dans le deuxième état de manière à avoir acquisition du signal.

Dans son état flottant, le photodétecteur 1 transforme un rayonnement lumineux en une charge électrique qui est stockée dans un noeud de rétention capacitif appelé noeud d'intégration N. De cette manière, l'information reçue par le photodétecteur 1 peut être stockée par la capacité interne du photodétecteur 1 matérialisée par le noeud d'intégration N.

Le circuit comporte également un circuit de lecture 4 qui traite l'information stockée dans le noeud d'intégration N pour générer un signal représentatif de la scène observée par la photodiode afin de l'envoyer à un circuit d'analyse (non représenté à la sortie du circuit de lecture). Le circuit de lecture 4 et le circuit de polarisation 3 n'étant pas parfaits, ils introduisent une ou plusieurs capacités électrique dans le circuit de détection en plus du condensateur interne du photodétecteur 1. De même, les lignes électriques utilisées pour imposer des polarisations ou pour faire transiter des charges dans le circuit introduisent également des capacités parasites. Toutes ces capacités parasites modifient le comportement du circuit car la valeur de capacité électrique associée au noeud d'intégration N n'est pas égale à la valeur de la capacité interne 2 du photodétecteur 1 mais à la somme des contributions des différentes capacités présentes dans le circuit. Cette association de capacités modifie la réponse du circuit par rapport à son comportement théorique.

Afin de réduire l'influence des capacités parasites lors de la lecture de l'information stockée dans le noeud d'intégration N, le circuit comporte un blindage métallique 5 qui est disposé de manière à entourer le noeud d'intégration N. Le blindage 5 entoure physiquement le noeud d'intégration N avec un ou plusieurs écrans qui sont matérialisés par des lignes électriquement conductrices, qui sont métalliques.

Le blindage 5 est connecté à une sortie du circuit de lecture 4 qui est configurée de manière à présenter une évolution du potentiel dans le même sens que celui du noeud d'intégration. L'évolution des potentiels du blindage 5 et du noeud d'intégration N dans le même sens permet de réduire l'influence des capacités parasites voire préférentiellement d'annuler les capacités parasites si le potentiel appliqué au blindage suit le potentiel du noeud d'intégration. Les charges aux bornes des capacités parasites sont alors constantes durant la lecture car elles ne voient pas d'évolution dans leurs conditions de polarisation. Le blindage 5 forme un blindage électrique ou un écrantage électromagnétique.

En comparaison d'un blindage associé à un potentiel fixe, l'évolution dans le même sens des potentiels du blindage et du noeud d'intégration permet de réduire la différence de potentiel qui existe entre le noeud d'intégration et le blindage. Cela permet de réduire l'influence des capacités parasites.

Dans un mode de réalisation préférentiel, la sortie du circuit de lecture 4 est configurée de manière à présenter une différence de potentiel constante avec la valeur du noeud d'intégration N. De cette manière, lors de la lecture de l'information stockée dans le noeud d'intégration N, les évolutions du potentiel du noeud d'intégration N sont semblables aux évolutions de potentiel du blindage métallique 5. La différence de potentiel entre le noeud d'intégration N et le blindage métallique 5 est constante et suit les variations du noeud d'intégration N.

Comme la différence de potentiel entre le noeud d'intégration N et le blindage 5 est constante cela permet d'éliminer virtuellement une partie des capacités parasites du circuit. La valeur de capacité associée au noeud d'intégration N se rapproche alors de la valeur de la capacité du photodétecteur 1.

Dans un mode de réalisation particulier illustré à la figure 3, le blindage entoure la ligne servant à la polarisation du photodétecteur 1, c'est-à-dire autour de la ligne reliant le circuit de polarisation 3 au photodétecteur 1. De manière plus particulière, le blindage 5 entoure la ligne qui relie la sortie du dernier transistor 6 du circuit de polarisation 3 à une première électrode du photodétecteur 1. Ce mode de réalisation permet de réduire fortement la valeur de capacité parasite associée au circuit de polarisation 3.

Dans une variante de réalisation non représenté, le blindage 5 est également réalisé autour du dernier transistor du circuit de polarisation 6 afin de réduire l'influence des capacités parasites.

Dans un autre mode de réalisation qui peut être combiné aux modes de réalisation précédents, le blindage 5 est disposé, au moins partiellement autour de la ligne qui relie l'entrée du circuit de lecture 4 à la première électrode du photodétecteur 1 comme cela est illustré à la figure 3.

Dans une variante de réalisation du mode précédent et illustrée à la figure 3, le blindage 5 est également disposé dans le circuit de lecture 4 autour d'un ou plusieurs transistors faisant transiter l'information contenue dans le noeud d'intégration N (figure 3).

Dans un mode de réalisation préférentiel, le premier transistor du circuit de lecture 4 qui reçoit l'information du noeud d'intégration N est complètement entouré par le blindage afin de réduire fortement l'effet des capacités parasites comme cela est illustré à la figure 3.

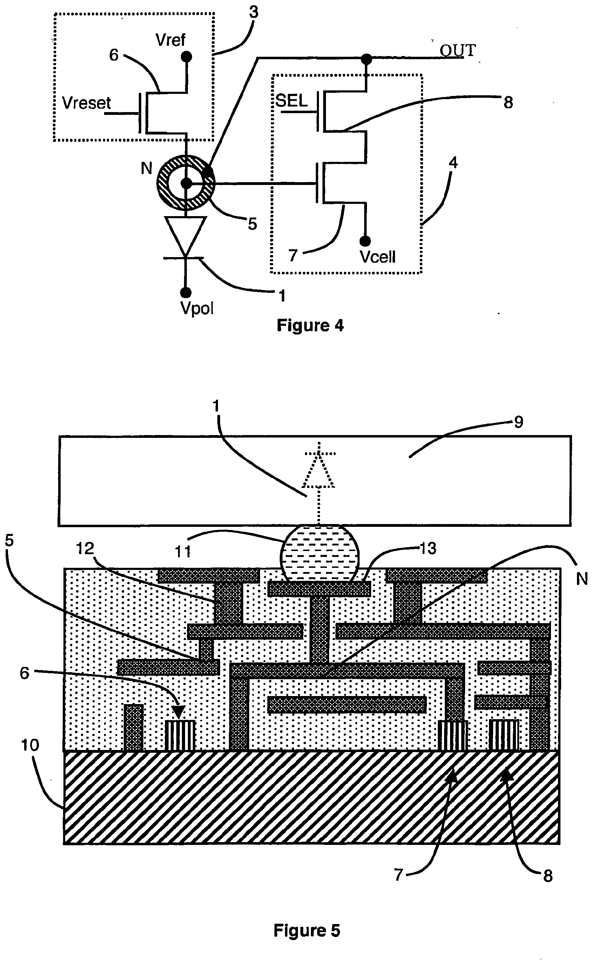

Dans un mode particulier de réalisation illustré aux figures 3 et 4 et qui peut être combiné avec les modes de réalisation précédents, le circuit de lecture 4 comporte un transistor suiveur 7. Le circuit de lecture 4 comporte un transistor suiveur 7 avec une électrode qui est connectée à un noeud électrique configuré de manière à avoir un potentiel qui évolue dans le même sens que le potentiel présent au noeud d'intégration N. Dans un mode de réalisation plus particulier, le transistor suiveur 7 présente une électrode de commande reliée au noeud d'intégration N et une autre électrode reliée à la sortie du circuit de lecture 4 de manière plus ou moins directe. Ainsi, la valeur du potentiel du noeud d'intégration N appliqué sur l'électrode de commande du transistor suiveur 7 modifie la valeur du signal délivré en sortie du transistor 7.

Le transistor suiveur 7 est préférentiellement un transistor à effet de champ avec une électrode de grille reliée au noeud d'intégration et une électrode de source/drain reliée à la sortie du circuit de lecture 4.

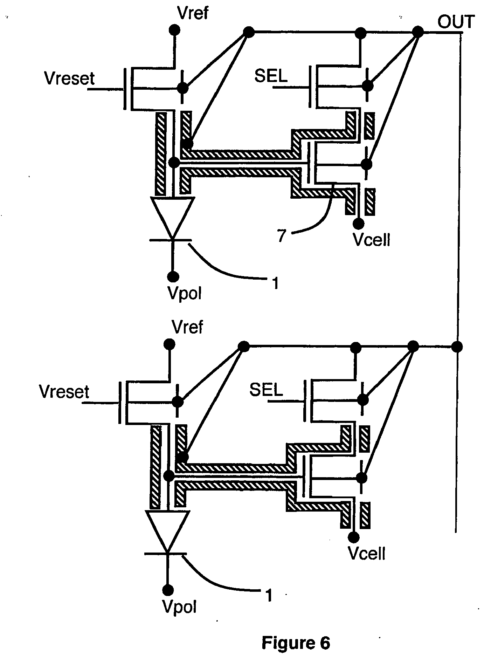

Dans un mode particulier de réalisation illustré aux figures 3 et 6 et qui peut être combiné avec les modes de réalisation précédents, la sortie du circuit de lecture 4 est connectée au substrat du premier transistor 6 du circuit de polarisation 3 de manière à appliquer artificiellement le blindage sous le canal du premier transistor 6 qui est alors un transistor à effet de champ.

Dans un autre mode particulier de réalisation qui peut être combiné avec les modes de réalisation précédents, la sortie du circuit de lecture 4 est connectée au substrat du transistor suiveur 7 du circuit de lecture 4 qui est alors un transistor à effet de champ. Comme précédemment, cela permet de faire continuer le blindage 5 sous le canal du transistor.

Dans une variante préférentielle de réalisation, la sortie du circuit de lecture 4 est connectée au substrat d'un ou plusieurs autres transistors du circuit de lecture 4.

Dans un mode de réalisation particulier qui peut être combiné avec les modes de réalisation précédents, la seconde électrode de source/drain du transistor suiveur 7 est reliée à un premier potentiel Vcell. Ce premier potentiel est variable et suit les variations du noeud d'intégration N afin de réduire l'influence des capacités parasites.

Dans un mode de réalisation particulier qui peut être combiné avec les modes de réalisation précédents et illustré à la figure 5, le photodétecteur 1 est réalisé sur un premier substrat 9. Le photodétecteur 1 provient d'un empilement classique de couches semi-conductrices afin de former par exemple une jonction de type PN et des couches électriquement conductrices pour imposer le potentiel Vpol. Le photodétecteur est représenté par un pointillé dans le premier substrat 9. Le circuit de polarisation 3 et le circuit de lecture 4 sont réalisés sur un second substrat 10. Les circuits sont matérialisés à titre d'exemple par les transistors 6, 7 et 8. Le photodétecteur 1 et les circuits de lecture 4 et de polarisation 3 sont connectés ensemble au moyen d'une bille métallique 11 qui réalise la connexion électrique entre les deux substrats. Le blindage 5 comporte un cadre 12 réalisé autour de la bille 11, de préférence à la surface du second substrat et relié à l'entrée du circuit de lecture 4. Ce mode de réalisation permet de limiter l'influence des capacités parasites présentes dans la zone d'hybridation. Le cadre 12 forme un anneau autour de la bille 11. Le cadre 12 est connecté à la sortie du circuit de lecture 4 soit directement soit dans la continuité du blindage 5.

De manière préférentielle, le cadre 12 comporte une partie supérieure disposée à une distance prédéterminée autour du contact électrique 13 avec la bille 11. De cette manière, il existe une zone isolante annulaire qui est comprise entre deux zones électriquement conductrices. Le cadre 12 comporte éventuellement une partie inférieure disposée dans un autre plan qui est disposé en regard de la zone isolante de manière à recouvrir au moins partiellement la zone isolante. Cette architecture particulière permet de couper les lignes de champ passant à travers la zone isolante et de réduire l'effet des capacités parasites.

Le cadre 12 peut être ensuite relié au blindage 5 par une ouverture de contact de large dimension dans la zone isolante ou par une multitude de contacts élémentaires à travers la couche isolante si la technologie de fabrication n'autorise pas l'ouverture de contacts de larges dimensions. De manière préférentielle, on cherche à augmenter les écrantages du noeud d'intégration N et des lignes électriques liant le noeud N à la bille 11, au transistor 6 et au transistor suiveur 7. Le blindage peut être matérialisé par un anneau plus ou moins continu disposé de manière à entourer le noeud N et des lignes. A titre d'exemple, le blindage 5 est connecté sur une électrode de source/drain du transistor 8.

Le blindage 5 et le cadre 12 sont préférentiellement formés dans les niveaux d'interconnexions électriques du circuit afin d'être intégrés au plus près des capacités parasites. De manière préférentielle, le blindage et le cadre sont formés dans les niveaux d'interconnexion électrique du second substrat 10 en même temps que les lignes électriques qui connectent les transistors entre eux et à la bille 11. Le blindage 5 est disposé dans un matériau électriquement isolant, entre la bille 11 et le substrat semi-conducteur comportant le circuit de lecture 4.

Le blindage 5 et le cadre 12 sont formés par un ou plusieurs matériaux électriquement conducteurs, par exemple avec du semi-conducteur dopé ou avec du métal. De manière préférentielle, le blindage et le cadre sont formés dans le même matériau que les lignes conductrices reliant le noeud d'intégration aux différents éléments du circuit. De manière encore plus préférentielle, le blindage et le cadre sont réalisés en matériau métallique afin d'avoir un effet important sur les capacités parasites.

Le circuit de détection de type SFD est illustré à titre d'exemple avec trois transistors à effet de champs, mais il est également possible d'obtenir un fonctionnement similaire avec un nombre différent de transistors.

Dans les différents modes de réalisation illustrés, le photodétecteur 1 est une photodiode ayant une première borne connectée à un potentiel de substrat Vpol. La seconde borne du photodétecteur est connectée au circuit de polarisation 3 qui est ici représenté par un transistor 6 à effet de champ.

Le circuit représenté correspond par exemple à un circuit d'une matrice de détection comportant une pluralité de circuits.

Le transistor 6 du circuit de polarisation 3 est connecté entre première borne de polarisation qui applique une tension de référence Vref et la seconde borne du photodétecteur 1.

La seconde borne du photodétecteur 1 est connectée à l'entrée du circuit de lecture 4 qui est matérialisée par l'électrode de grille du transistor suiveur 7. Le transistor suiveur 7 et un transistor de sélection 8 sont connectés en série par une première électrode commune. La seconde électrode du transistor suiveur 7 est connectée à un premier potentiel Vcell. La seconde électrode du transistor de sélection 8 est connectée à une ligne de sortie OUT qui peut être commune à plusieurs circuits. L'électrode de grille du transistor de sélection 8 est connectée à une borne de sélection qui reçoit un signal de sélection SEL permettant de passer le transistor 8 dans un état passant ou bloqué.

Le noeud d'intégration N du circuit est schématisé par la connexion commune entre le photodétecteur 1, le transistor 6 du circuit de polarisation 3 et le transistor suiveur 7. Cependant, les charges provenant du photodétecteur 1 sont stockées en partie dans le condensateur interne du photodétecteur 1 et en partie dans les condensateurs parasites présents par exemple dans les transistors utilisés et dans les lignes métalliques.

Le blindage 5 entoure physiquement le noeud d'intégration N avec une ou plusieurs lignes électriques. De manière préférentielle illustrée, le blindage 5 est également disposé de manière à entourer l'une des composantes capacitives formant le noeud d'intégration N par exemple, de manière à entourer la ligne reliant le transistor de polarisation 6 au photodétecteur 1 et/ou de manière à entourer la ligne reliant l'électrode de grille du transistor suiveur au photodétecteur.

Dans l'exemple illustré, le blindage 5 est disposé de manière à entourer les différentes composantes parasites provenant du circuit de polarisation 3 et du circuit de lecture 4.

En plus, les substrats du transistor de polarisation 4, du transistor suiveur 7 et du transistor de sélection 8 sont connectés à la ligne de sortie OUT de manière à avoir une très forte baisse des capacités parasites.

Dans un mode de réalisation préférentiel, le circuit de polarisation 3 et/ou le circuit de lecture 4 sont recouverts par un matériau électriquement isolant à l'intérieur duquel une ou plusieurs lignes métalliques sont formées pour connecter les différents éléments entre eux. Les lignes métalliques sont réalisées dans les niveaux d'interconnexion métallique du circuit. De manière préférentielle, le blindage métallique 5 est réalisé dans les niveaux d'interconnexion du circuit afin d'être au plus près des lignes métalliques servant au transit du signal. Cela permet d'avoir un effet important sur les capacités parasites.

Comme cela est illustré à la figure 6, le circuit de détection peut être intégré en matrice de détection avec une pluralité de circuits de détection organisés selon une ou deux dimensions.

Lorsque plusieurs circuits sont associés pour former un groupe de détecteurs, par exemple une ligne de détection, les circuits sont avantageusement reliés par une ligne de sortie OUT qui est connectée aux bornes de sortie des différents circuits de lecture 4.

De cette manière, les signaux émis par les différents circuits de lecture 4 transitent par la même ligne de sortie OUT à des instants différents. Les circuits de détection présentent une entrée de sélection afin d'éviter le transit simultané de deux circuits de la même ligne de détection.

Dans un mode de réalisation préférentiel, la ligne de sortie OUT est connectée au blindage métallique 5 de ses circuits associés. Le potentiel de la ligne de sortie OUT évolue dans le temps au fur et à mesure du transit des signaux provenant des différents circuits. Cependant, le potentiel de la ligne de sortie OUT est lié au potentiel du noeud d'intégration N qui est en train d'être lu. Ainsi, durant la phase de lecture, le potentiel de la ligne de sortie OUT évolue dans le même sens que le potentiel du noeud d'intégration N ce qui permet de limiter l'influence des condensateurs parasites. Selon l'architecture du circuit de lecture utilisé, la différence de potentiel entre la ligne de sortie OUT et le noeud d'intégration N est constante durant la phase de lecture. Le potentiel de la ligne de sortie OUT évolue dans le temps et se déplace en fonction des différents noeuds d'intégration N, au fur et à mesure de leur lecture.

Dans son fonctionnement, le photodétecteur 1 est polarisé en inverse en basculant le transistor de polarisation 6 à l'état passant. Le photodétecteur 1 est polarisé entre le potentiel de référence Vref et le potentiel de polarisation Vpol.

Le transistor de polarisation 6 est ensuite passé à l'état bloqué et le photodétecteur 1 se retrouve dans un état flottant. Durant cette période à l'état flottant, le photodétecteur 1 transforme le rayonnement lumineux reçu en une certaine quantité d'électrons représentatifs de la scène observée. L'évolution du potentiel présent au noeud d'intégration N représente le signal fourni par le photodétecteur 1 sur la scène observée. Le potentiel du noeud d'intégration N est appliqué sur l'électrode de commande du transistor suiveur 7. Dans une intégration en matrice, il est préférable que tous les photodétecteurs 1 réalisent l'acquisition de la scène observée pendant la même durée d'intégration.

Lors de la phase de lecture, le potentiel en sortie du transistor suiveur 7 (sur la première électrode) et le potentiel en sortie du transistor de sélection 8 (sur sa seconde électrode) évoluent dans le même sens que le potentiel du noeud d'intégration N. Ainsi, la ligne de sortie OUT reçoit un signal représentatif de la scène observée au moyen du noeud d'intégration N. En plus, le blindage métallique 5 disposé de manière à entourer le noeud d'intégration N varie avec la valeur de potentiel du noeud N ce qui limite les transferts de charges électriques d'une phase de lecture à la phase de lecture suivante. De manière préférentielle, la valeur représentative de la scène observée est l'évolution du potentiel du noeud d'intégration N par rapport à sa valeur initiale. De manière encore plus préférentielle, la valeur représentative de la scène observée est l'évolution du potentiel du noeud d'intégration N entre deux lectures successives, par exemple avec une technique de double échantillonnage corrélé (Correlated Double Sampling).

Le blindage métallique 5 forme un dispositif d'écrantage dans le circuit de détection ce qui permet de réduire voire d'éliminer virtuellement les capacités parasites. Le dispositif présente alors des performances en sensibilité accrues et un niveau de bruit diminué en terme d'électrons de bruit.

## Revendications

1. Circuit de détection de type Source Follower per Detector comportant :
- une photodiode (1) connectée à un noeud d'intégration (N) capacitif,
- un circuit de polarisation (3) configuré de manière à polariser la photodiode (1) entre un premier état où la photodiode est polarisée en inverse et un deuxième état d'acquisition où la photodiode est à un potentiel flottant et génère des charges électriques qui sont stockées dans le noeud d'intégration (N),
- un circuit de lecture (4) connecté au noeud d'intégration (N) pour générer un signal représentatif de la scène observée par la photodiode (1),
- un blindage métallique (5) connecté à une sortie du circuit de lecture (4) configurée de manière à avoir un potentiel qui évolue dans le même sens que le potentiel présent au noeud d'intégration (N),
**caractérisé en ce que**
le blindage métallique (5) est disposé de manière à entourer le noeud d'intégration (N) et
la photodiode (1) est directement connectée au noeud d'intégration (N).

2. Circuit selon la revendication 1, **caractérisé en ce que** le circuit de lecture (4) comporte un transistor suiveur (7) ayant une électrode connectée à un noeud électrique configuré de manière à avoir un potentiel qui évolue dans le même sens que le potentiel présent au noeud d'intégration (N).

3. Circuit selon la revendication 2, **caractérisé en ce que** le transistor suiveur (7) a une électrode de commande connectée au noeud d'intégration (N) et une autre électrode électriquement liée au blindage métallique (5).

4. Circuit selon l'une quelconque des revendications 1 et 3, **caractérisé en ce que** le blindage métallique (5) est connecté à une sortie du circuit de lecture (4) configurée pour présenter une différence de potentiel constante avec le potentiel présent au noeud d'intégration (N).

5. Circuit selon l'une quelconque des revendications 1 à 4, **caractérisé en ce que** le blindage métallique (5) entoure la ligne électrique reliant la photodiode (1) au circuit de polarisation (3).

6. Circuit selon l'une quelconque des revendications 1 à 5, **caractérisé en ce que** le blindage métallique (5) entoure la ligne électrique reliant le noeud d'intégration (N) au circuit de lecture (4).

7. Circuit selon l'une quelconque des revendications 1 à 6, **caractérisé en ce que** la photodiode (1) est formée sur un premier substrat (9), le circuit de polarisation (3) et le circuit de lecture (4) sont formés sur un second substrat (10), la photodiode (1) étant reliée au circuit de polarisation (3) et de lecture (4) au moyen d'une bille métallique (11), la bille métallique (11) est entourée par un anneau métallique (12) connecté à la sortie du circuit de lecture (4).

8. Circuit selon la revendication 7, **caractérisé en ce que** le blindage métallique (5) est disposé dans un matériau électriquement isolant, entre la bille métallique (11) et le substrat semi-conducteur comportant le circuit de lecture (4).

9. Matrice de détection comprenant une pluralité de circuits selon l'une quelconque des revendications 1 à 8, chaque circuit de lecture (4) comportant une entrée de sélection spécifique, une ligne de sortie (OUT) étant connectée à la borne de sortie des circuits de lecture (4).

10. Matrice de détection selon la revendication 9, **caractérisée en ce que** la ligne de sortie (OUT) est connectée au blindage métallique (5).

## Patentansprüche

1. Detektorschaltkreis des Typs "Source Follower per Detector", welcher umfasst:
- eine Fotodiode (1), die mit einem kapazitiven Integrationsknoten (N) verbunden ist,
- eine Polarisationsschaltung (3), die dergestalt konfiguriert ist, dass sie die Fotodiode (1) polarisiert, und zwar zwischen einem ersten Zustand, in dem die Fotodiode umgekehrt polarisiert ist, und einem zweiten, einem Erfassungszustand, in dem die Fotodiode ein schwebendes Potential aufweist und elektrische Ladungen erzeugt, die in dem Integrationsknoten (N) gespeichert werden,
- eine Leseschaltung (4), die mit dem Integrationsknoten (N) verbunden ist, um ein Signal zu erzeugen, das die von der Fotodiode (1) aufgenommene Szene darstellt,
- eine metallene Abschirmung (5), die mit einem Ausgang der Leseschaltung (4) verbunden ist, welcher dergestalt konfiguriert ist, dass er ein Potential aufweist, das sich in der gleichen Richtung entwickelt wie das an dem Integrationsknoten (N) vorhandene Potential,
**dadurch gekennzeichnet,**
**dass** die metallene Abschirmung (5) dergestalt angeordnet ist, dass sie den Integrationsknoten (N) umgibt, und die Fotodiode (1) direkt mit dem Integrationsknoten (N) verbunden ist.

2. Schaltkreis nach Anspruch 1,
**dadurch gekennzeichnet,**
**dass** die Leseschaltung (4) einen Folgetransistor (7) enthält, der eine Elektrode aufweist, die mit einem elektrischen Knotenpunkt verbunden ist, der dergestalt konfiguriert ist, dass er ein Potential aufweist, das sich in der gleichen Richtung entwickelt wie das an dem Integrationsknoten (N) vorhandene Potential.

3. Schaltkreis nach Anspruch 2,
**dadurch gekennzeichnet,**
**dass** der Folgetransistor (7) eine Steuerelektrode aufweist, die mit dem Integrationsknoten (N) verbunden ist, sowie eine weitere Elektrode, die elektrisch mit der metallenen Abschirmung (5) verbunden ist.

4. Schaltkreis nach einem der Ansprüche 1 und 3,
**dadurch gekennzeichnet,**
**dass** die metallene Abschirmung (5) mit einem Ausgang der Leseschaltung (4) verbunden ist, welcher dergestalt konfiguriert ist, dass er eine konstante Potentialdifferenz zu dem Potential aufweist, das an dem Integrationsknoten (N) vorhanden ist.

5. Schaltkreis nach einem der Ansprüche 1 bis 4,
**dadurch gekennzeichnet,**
**dass** die metallene Abschirmung (5) die elektrische Leitung umgibt, die die Fotodiode (1) mit der Polarisationsschaltung (3) verbindet.

6. Schaltkreis nach einem der Ansprüche 1 bis 5,
**dadurch gekennzeichnet,**
**dass** die metallene Abschirmung (5) die elektrische Leitung umgibt, die den Integrationsknoten (N) mit der Leseschaltung (4) verbindet.

7. Schaltkreis nach einem der Ansprüche 1 bis 6,
**dadurch gekennzeichnet,**
**dass** die Fotodiode (1) auf einem ersten Substrat (9) gebildet ist, die Polarisationsschaltung (3) und die Leseschaltung (4) auf einem zweiten Substrat (10) gebildet sind, wobei die Fotodiode (1) mittels einer Metallkugel (11) mit der Polarisationsschaltung (3) und der Leseschaltung (4) verbunden ist, die Metallkugel (11) von einem Metallring (12) umgeben ist, der mit dem Ausgang der Leseschaltung (4) verbunden ist.

8. Schaltkreis nach Anspruch 7,
**dadurch gekennzeichnet,**
**dass** die metallene Abschirmung (5) in einem elektrisch isolierenden Material zwischen der Metallkugel (11) und dem Halbleiter-Substrat, das die Leseschaltung (4) aufweist, angeordnet ist.

9. Detektor-Matrix, die eine Vielzahl von Schaltkreisen nach einem der Ansprüche 1 bis 8 enthält, wobei jede Leseschaltung (4) einen eigenen Wahleingang besitzt, wobei eine Ausgangsleitung (OUT) mit der Ausgangsklemme der Leseschaltungen (4) verbunden ist.

10. Detektor-Matrix nach Anspruch 9,
**dadurch gekennzeichnet,**
**dass** die Ausgangsleitung (OUT) mit der metallenen Abschirmung (5) verbunden ist.

## Claims

1. Detection circuit of the Source-Follower per Detector type comprising:
- a photodiode (1) connected to a capacitive integration node (N),
- a biasing circuit (3) configured so as to bias the photodiode (1) between a first state where the photodiode is reverse-biased and a second acquisition state where the photodiode is at a floating potential and provides electrical charges stocked in the integration node (N),
- a readout circuit (4) connected to the integration node (N) for generating a signal representative of the scene observed by the photodiode (1),
- a metal shielding (5) connected to an output of the readout circuit (4) configured to have a potential varying in the same direction as the potential at the integration node (N),
**characterized in that**
the metal shielding (5) is arranged so as to surround the integration node (N) and
the photodiode is directly connected to the integration node.

2. Circuit according to claim 1, **characterized in that** the readout circuit (4) comprises a follower transistor (7) having an electrode connected to an electrical node configured so as to have a potential varying in the same direction as the potential at the integration node (N).

3. Circuit according to claim 2, **characterized in that** the follower transistor (7) has a control electrode connected to the integration node (N) and another electrode electricaly linked to the metal shielding (5).

4. Circuit according to any one of the claims 1 to 3, **characterized in that** metal shielding (5) is connected to an output of the readout circuit (4) configured to have a constant potential difference relative to the potential at the integration node (N).

5. Circuit according to any one of the claims 1 to 4, **characterized in that** the metal shielding (5) surrounds the electric power line connecting the photodiode (1) to the biasing circuit (3).

6. Circuit according to any one of the claims 1 to 5, **characterized in that** the metal shielding (5) surrounds the electric power line connecting the integration node (N) to the readout circuit (4).

7. Circuit according to any one of the claims 1 to 6, **characterized in that** the photodiode (1) is made on a first substrate (9), the biasing circuit (3) and the readout circuit (4) are made on a second substrate (10), the photodiode being connected to the biasing circuit (3) and the readout circuit (4) by means of a metal bump (11), the metal bump (11) being surrounded by a metal ring (12) connected to the output of the readout circuit (4).

8. Circuit according to claim 7, **characterized in that** the metal shielding (5) is arranged in a electrically insulating material, between the metal bump (11) and the semiconductor substrate comprising the readout circuit (4).

9. Detection matrix including a plurality of circuits according to any one of the claims 1 to 8, each readout circuit (4) comprising a specific selecting input, an output line (OUT) being connected to the output terminal of the readout circuits (4).

10. Detection matrix according to claim 9, **characterized in that** the output line (OUT) is connected to the metal shielding (5).
